# EUROPEAN PATENT APPLICATION

(11) **EP 1 255 208 A1**
(43) Date of publication of application: **06.11.2002**
(21) Application number: 02291045.9
(22) Date of filing: 24.04.2002
(51) Int. Cl.: G06F 17/30, G01D 4/00, G01R 22/00, G06F 17/60

(54) **Method and metering system for metering the use of electronic devices**

(30) Priority: 01.05.2001 NL 1017971
(71) Applicant: Atos Origin Telco Services B.V., 9728 HD Groningen (NL)
(72) Inventor: Burgman, Herman Antonius Jozef, 9407 GP Assen (NL)
(74) Representative: de Roquemaurel, Bruno

(57) **Abstract**

A method of metering the use of electronic devices (21-24), which method comprises: the metering of at least one predetermined quantity which constitutes a measure of the use of at least one electronic device linked with a metering system (10); the storage of at least one result of the metering of said at least one quantity in at least one data file (213, 223, 233, 243); the retrieval by the metering system (10) of at least one of the metering results stored in said data file (213, 223, 233, 243) from at least one of said data files (213, 223, 233, 243); the conversion of the metering result into units of use by the metering system (10) in accordance with at least one predetermined conversion method; the storage of said units of use in a data file (135) in a memory (13) of the metering system (10).

## Description

The invention relates to a method for metering the use of electronic devices. The invention also relates to a server system, a client system and a network system arranged for carrying out such a method.

Such a method is known from US patent publication no. 6,016,509. Said '509 publication discloses a method in which the use of a database is metered via a metering system. According to said method the database is approached with a client system of a user via a metering system. The metering system is capable of metering the use of the database as well as calculating the costs of said use.

One drawback of the known method is the fact that it is not very suitable for metering the use of a large number of electronic devices. When the use of a great number of devices is to be metered, the metering system will be loaded very heavily. This is caused by the fact that the data traffic between the client system and the database takes place via the metering system, since the client system and the databases are linked by means of the metering system.

The object of the invention is to overcome this drawback. This objective can be accomplished by a method, wherein the use of electronic devices is registered by the electronic devices themselves and wherein the registered data are retrieved by a metering system.

The data traffic between database and client system takes place outside the metering system, so that the metering system will also be capable of metering the use of a large number of electronic devices without the risk of the metering system being overloaded.

The invention also provides a metering system. Such a system can be used for carrying out the method according to the invention.

It is possible to combine the various other embodiments of the invention as described in the text and defined in the claims.

Further details and aspects of the invention will now be discussed with reference to the figures illustrated in the drawing.

Fig. 1 shows a schematic topology of a network for carrying out a method according to the invention.

Fig. 2 shows a block diagram of an example of a metering system according to the invention.

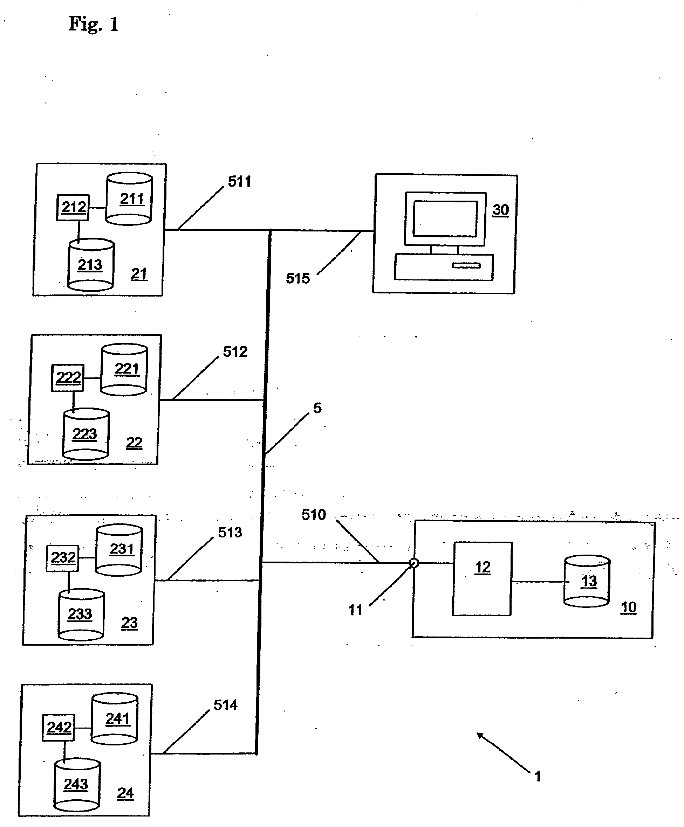

The example of a network 1 according to the invention that is shown in Fig. 1 comprises a metering system 10, database servers 21-24 and a client system 30, which are linked via connections 5,510-515. The servers 10,21-24 and the client system 30 comprise network communications devices not shown in the figure. The network communications devices enable the servers and the client systems to communicate with each other.

Only one client system 30 is shown in Fig. 1. The network 1 may comprise several client systems, however, and each of the database servers may be linked with several client systems. Thus, a database server may be linked with fewer than ten, a few dozen or a few hundred client systems in a company network. In a Wide Area Network (WAN) environment or an Internet environment, for example, any number of client computers may be used, the number may for example range from a few dozen to several thousand or several million computers. The connections 5,511-515 may be of any suitable type. For example, the connections may be in the form of coax cables, glass fibre cables or wireless communication systems, such as infrared or radio transmission connections. The communication over the connections 5,511-515 can take place via any suitable protocol, for example via Ethernet TCP/IP, Bluetooth or otherwise.

Each of the database servers 21-24 has a memory which comprises a database 211, 221, 231, 241. The client system 30 is linked with the databases 211, 221, 231, 241 and a user of the client system 30 can retrieve information from said databases or use the databases otherwise.

In Fig. 1, the database servers 21-24 and the client system 30 are not linked via the metering system 10, as a result of which the metering system 10 is not loaded with data traffic between the database servers and client systems. Any type of database is possible, for example jurisprudence databases, databases containing scientific publications, databases containing personal particulars or other databases. Although the electronic devices are database servers in the illustrated network 1, the electronic devices may also be of another type whose use is to be metered, for example a telecommunication device (such as a telephone exchange), an Internet server, a network server or, for example, an Internet radio server. The electronic devices may also be application service provider (ASP) servers. ASP servers are systems which execute a program code on a user's system via a network or which transmit a program code to a system, which program code is subsequently executed by said system. An ASP server may be linked with the user's system via the Internet, for example, in which case the ASP server executes a Java application, for example. The electronic devices may also be a single file or a database, for example, or a computer network or a communication network.

In the illustrated database servers 21-24, a control unit 212, 222, 232, 242 is linked with the databases 211, 221, 231, 241. The control unit is arranged for metering the use of databases 211, 221, 231, 241. To that end, the control unit records a number of data for each client system or user of the database in a metering table in a metering database 213, 223, 233, 243. Said data comprise at least an indication of the user and the metered value of the quantity associated with the user.

The server system 10 is capable of retrieving the metering tables stored in the databases 213, 223, 233, 243 and convert the use into units of use per metered quantity on the basis of arithmetic rules stored in an arithmetic rules database 133 in the memory 13. Said units of use constitute a measure of the costs of the use of electronic devices. The units of use are calculated per metered quantity for the user, so that the user can obtain a detailed insight into the costs of said use. The user can adapt his use on the basis of this insight in order to thus minimise said costs. The administrator of the database can obtain this cost overview as well, so that he will be able to adjust his conditions to said use, for example by making the user a special offer or drawing the user's attention to a more economical type of subscription.

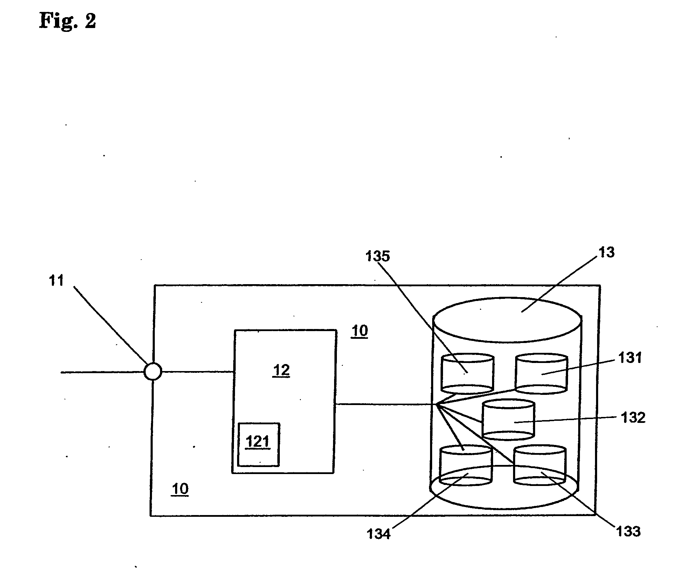

Figure 2 shows a more detailed block diagram of the metering system of Fig. 1. A gate 11 of the metering system 10 is communicatively linked with a control unit 12. The control unit 12 is linked with a memory 13, which comprises a number of databases 131-135. The control unit 12 is furthermore linked with the client system 30 via the gate 11 and the connections 5,510-515. The metering system is furthermore linked with the client systems (not shown in the drawing) via the gate 11 and the connections 5,510.

The control unit 12 is arranged for periodic retrieval of the data from the metering databases 213, 223, 233, 243 of the database servers 21-24. An installed base database 131 is stored in the memory 13, which database contains information on the configuration of the database servers that are linked with the metering system. This may for example be the service level that the user and the administrator of the database server have agreed upon in a so-called service level agreement (SLA), the location of the database server, the security, the quantities to be retrieved and/or the location of the metering database. The control unit 12 is provided with a program code which enables the control unit to retrieve the relevant metering data from the respective database servers 21-24 on the basis of the data in the installed base database 131. In the illustrated example, the server 10 is an ORACLE database server which is capable of retrieving data from the databases via a PL/SQL procedure, using the SQL*NET programme. PL/SQL is a programming language from the Oracle company. The commands of the PL/SQL procedure that is to be executed in order to retrieve the metering data from a database server are stored in the installed base database, where they are coupled to the database server in question.

The retrieved metering data are subsequently stored in a metering database 132 in the memory 13. The control unit 12 subsequently executes a PL/SQL procedure, by means of the arithmetic rules stored in the arithmetic rules database 133, using variables stored in a parameter database 134 and the metering results stored in the metering database 132. The results of said arithmetic procedure are subsequently stored in an output database 135. Alternatively, the arithmetic rules may be stored in the installed base database per database server. In that case there is no need for a separate arithmetic rules database in the memory 13.

The client system 30 is linked with the metering system 10 via a number of connections 5,510,515. This enables a user of the client system 30 to access the memory 13 and the output database 135 that is stored therein, in which the units of use that have been calculated per metered quantity are registered. As a result, the user can gain an insight into the structure of the costs of the use of the databases 211, 221, 231, 241. This enables the user to tune the use of the databases to the cost structure in order to thus minimise the costs.

In the illustrated example, the user of the client system can retrieve data from the output database 135 by means of a Web browser program, such as Microsoft Internet Explorer or Netscape Navigator, in order to provide the user with a simple and generally usable possibility to gain an insight into the cost structure. The control unit 12 is to that end provided with a Web server program, which can make the data accessible, for example in the form of Web pages, via a suitable protocol, such as TCP/IP.

The invention is not restricted to the illustrated examples, and several variants will be obvious to a person skilled in the art who has read the foregoing. It will in particular be obvious to link more or fewer electronic devices with the metering system 10. Furthermore it will be obvious to a person skilled in the art to link the electronic devices with several users and to implement the links between the metering system 10, the electronic devices and the client system in a different manner. Furthermore it will be obvious to a person skilled in the art to give the user an insight in his use in a different manner, for example by printing the units of use that have been calculated per metered quantity on paper by means of the metering system 10 or to send these data to the user by e-mail.

## Claims

1. A method of metering the use of electronic devices, said method comprising:
the metering in accordance with predetermined metering rules of at least one predetermined quantity which constitutes a measure of the use of at least one electronic device linked with a metering system;
the storage of said at least one metered quantity in said electronic device;
the retrieval by the metering system of the stored metering results from at least one electronic device in accordance with rules stored in the metering system.

2. A method according to claim 1, wherein the metering result is converted into units of use by the metering system in accordance with at least one predetermined conversion method, and wherein said units of use are stored in a data file in a memory of the metering system.

3. A method according to claim 2, wherein at least one metering result is retrieved by the metering system from a data file which is stored in a memory of the metering system.

4. A method according to claim 3, wherein the retrieval of the metering results by the metering system is carried out on the basis of data relating to the electronic devices linked with the metering system, which data are stored in an installed base data file which is stored in the memory of the metering system.

5. A method according to claim 4, wherein said metering comprises the execution of metering commands which are stored in the installed base data file for each connected electronic device.

6. A method according to any one of the preceding claims, wherein at least one metering result is retrieved by the metering system from a data file which is stored in a memory of the electronic device.

7. A method according to claim 6, wherein the metering of said at least one predetermined quantity and the storage of at least one metering result in at least one data file comprise:
the metering of the use of the electronic device by means of said electronic device; and
the storage of a metering result thus obtained in a data file in a memory of the electronic device.

8. A method according to any one of the preceding claims, wherein the conversion of the metering result comprises:
the retrieval of at least one arithmetic rule from an installed base data file, in which installed base data file the arithmetic rules are linked with the metered electronic device.

9. A method according to any one of the preceding claims, further comprising the step of converting the calculated units of use into an amount of money by means of the metering system.

10. A method according to any one of the preceding claims, further comprising:
the outputting by the metering system of data relating to the calculated units of use and/or the amount of money.

11. A method according to claim 10, wherein said outputting of data comprises:
the displaying of the calculated units of use and/or the amount of money in a form which people are able to recognise.

12. A method according to claim 10 or 11, wherein said outputting of data comprises:
the transmission by means of the metering system of data which represent the calculated units of use and/or the amount of money to a client system which is linked with the metering system.

13. A method according to claim 12, wherein said transmission of data representing the calculated units of use and/or the amount of money comprises:
the transmission to the client system of a code which is suitable for being displayed by the client system in a form which people are able to recognise.

14. A method according to claim 13, wherein said code represents a World Wide Web page.

15. A method according to any one of the preceding claims, wherein at least one of said electronic devices comprises an electronic database.

16. A method according to any one of the preceding claims, at least one of the said electronic devices comprises a telecommunication device.

17. A method according to any one of the preceding claims, wherein at least one of said electronic devices is arranged for transmission to the client system of a program code which comprises instructions to be carried out by the client system.

18. A metering system, comprising:
at least one input gate which, in use, is communicatively linked with at least one electronic device;
a memory which is communicatively linked with at least one of the input gates, which memory comprises:
arithmetic data which represent a predetermined conversion rule for converting a metering result into calculated units of use; and
database data which represent a data file, which data file contains calculated units of use; and which metering system furthermore comprises:
a control unit which is communicatively linked with at least one of the input gates and with the memory, which control unit comprises a program code for:
the retrieval from a data file of:
at least one metering result stored in the data file of at least one predetermined, metered quantity which constitutes a measure of the use of at least one of the electronic devices; the conversion into units of use of the metering result in accordance with the conversion rule;
the storage in the data file of the units of use per metered quantity.

19. A metering system according to claim 18, wherein the memory furthermore comprises metering data comprising at least one metering result.

20. A metering system according to claim 18 or 19, wherein the control unit comprises a program code for retrieving the metering result from a data file which is stored in a memory of the electronic device.

21. A metering system according to claim 20, wherein the control unit furthermore comprises a program code for initiating:
the metering of the use of the electronic device by means of the electronic device; and
the storage of a metering result thus obtained in a data file in a memory of the electronic device.

22. A metering system according to any one of the claims 18-21, wherein the control unit also comprises a program code for conversion of the calculated units of use into an amount of money by the metering system.

23. A metering system according to any one of the claims 18-22, further comprising:
an output gate, and in which metering system the control unit furthermore comprises a program code for:
outputting the calculated units of use and/or the amount of money via the output gate.

24. A metering system according to claim 23, wherein the output gate is provided with a monitor for displaying the calculated units of use and/or the amount of money in a form which people are able to recognise.

25. A metering system according to claims 22 or 23, wherein the output gate is communicatively linked with a client system.

26. A metering system according to claim 25, wherein the control unit furthermore comprises a program code for:
transmission to the client system of a code which is suitable for being displayed by the client system in a form which people are able to recognise.

27. A metering system according to claim 26, wherein said code represents a World Wide Web page.

28. A metering system according to any one of the claims 18-27, wherein:
at least one of said electronic devices comprises an electronic database.

29. A metering system according to any one of the claims 17-28, wherein at least one of said electronic devices comprises a telecommunication device.

30. A metering system according to any one of the claims 18-29, wherein at least one of said electronic devices is arranged for transmission to the client system of a program code which contains instructions to be carried out by the client system.

31. A network assembly, comprising:
at least one electronic device;
a metering system according to any one of the preceding claims and the preceding text, which metering system is communicatively linked with said at least one electronic device.

32. A computer program, comprising a program code for executing steps of a method according to any one of the preceding claims and the preceding text.

33. An information carrier provided with data which represent a computer program according to claim 32.
